# DEMANDE DE BREVET EUROPEEN

(11) **EP 4 766 133 A1**
(43) Date de publication de la demande: **24.06.2026**
(21) Numéro de dépôt: 25223635.1
(22) Date de dépôt: 16.12.2025
(51) Int. Cl.: H10W 20/00, H10W 20/44, H10N 60/01

(54) **PROCÉDÉ DE RÉALISATION D'INTERCONNEXIONS**

(30) Priorité: 20.12.2024 FR 2414892
(71) Demandeur: Commissariat à l'Energie Atomique et aux Energies Alternatives, 75015 Paris (FR)
(72) Inventeur: CHÊNE, Thibaut, 38054 GRENOBLE Cedex 09 (FR); NEMOUCHI, Fabrice, 38054 GRENOBLE Cedex 09 (FR); SEGAUD, Roselyne, 38054 GRENOBLE Cedex 09 (FR); CHEVOLLEAU, Thierry, 38054 GRENOBLE Cedex 09 (FR)
(74) Mandataire: Hautier IP

(57) **Abrégé**

L'invention concerne un procédé de fabrication d'un niveau d'interconnexion comprenant :
• une formation, sur un substrat (S), d'une première couche métallique (21),
• une formation, sur la première couche métallique (21), d'une couche d'arrêt de gravure (30),
• une structuration de la couche d'arrêt de gravure (30),
• une formation, sur la couche d'arrêt de gravure structurée comprenant une ouverture de via (30v), d'une deuxième couche métallique (22),
• une formation, sur la deuxième couche métallique (22), d'un deuxième masque définissant un motif de via (40v) à l'aplomb de l'ouverture de via (30v),
• une gravure de la deuxième couche métallique (22), configurée pour former un via (61) sous le deuxième masque, puis
• une gravure de la première couche métallique (21), configurée pour former une ligne (62) sous la couche d'arrêt de gravure structurée, la ligne (62) étant connectée au via (61) au travers de l'ouverture de via (30v).

## Description

### DOMAINE TECHNIQUE

La présente invention concerne le domaine technique des interconnexions pour la microélectronique. Elle trouve pour application particulièrement avantageuse la formation de vias et de lignes d'interconnexion compatibles radiofréquence (RF).

### ETAT DE LA TECHNIQUE

Le développement de dispositifs microélectroniques basés sur des « bits quantiques » ou « Qubits », par exemple des qubits de spin ou des qubits supraconducteurs, nécessite la fabrication d'un routage d'interconnexions spécifique. Ces interconnexions sont notamment à base de matériaux métalliques différents du cuivre généralement utilisé dans les niveaux de lignes et de vias associés à la fabrication de dispositifs à base de transistors à effet de champ.

Le document EP3577700 divulgue différents procédés de réalisation de vias et de lignes métalliques adaptés à la fabrication de circuits supraconducteurs. Dans ce document, un via à base de niobium et/ou d'aluminium est formé sur un premier niveau de métal semiconducteur, typiquement à base de niobium, en intercalant une couche d'arrêt de gravure entre le via et le premier niveau de métal. Cette couche d'arrêt de gravure permet typiquement de mieux détecter la fin de gravure de la couche supraconductrice formant principalement le via. Selon ce document, cette couche d'arrêt de gravure peut être à base d'aluminium et présenter des propriétés supraconductrices dans un certain domaine de températures. Elle participe ainsi à la conduction entre le via et la ligne supraconductrice sous-jacente. Selon une autre possibilité divulguée dans le document EP3577700, la couche d'arrêt de gravure peut être à base d'un matériau diélectrique. Une ouverture au sein de cette couche d'arrêt de gravure est alors prévue afin de connecter le via avec la ligne supraconductrice sous-jacente. Cette approche requiert une pluralité d'étapes de lithographie/gravure et de polissage. Cela augmente la variabilité dimensionnelle, notamment en épaisseur, des dispositifs à l'échelle d'un wafer.

Une autre solution pour former les différents niveaux de lignes et de vias métalliques est basée sur l'adaptation des procédés de type « damascène ». Cette approche induit d'autres problématiques, notamment pour la gravure de la matrice diélectrique à faible constante diélectrique. Une augmentation de la constante diélectrique est typiquement observée lors de la gravure de la matrice diélectrique. La compatibilité RF est dégradée.

Un objet de la présente invention est de proposer un procédé de formation de lignes et de vias d'interconnexion palliant au moins en partie les inconvénients mentionnés ci-dessus.

En particulier, un objet de la présente invention est de proposer un procédé alternatif de formation de lignes et de vias d'interconnexion, présentant une reproductibilité améliorée.

### RESUME

Pour atteindre cet objectif, selon un mode de réalisation on prévoit un procédé de fabrication d'un niveau d'interconnexion comprenant au moins une ligne à base d'un premier matériau métallique A et au moins un via à base d'un deuxième matériau métallique B, ledit procédé comprenant :
- une fourniture d'un substrat,
- une formation, sur le substrat, d'une première couche métallique à base du premier matériau métallique A,
- une formation, sur la première couche métallique, d'une couche d'arrêt de gravure à base d'un matériau diélectrique C présentant une sélectivité S_{A:C} à la gravure vis-à-vis du premier matériau A typiquement supérieure ou égale à 5:1,
- une structuration de la couche d'arrêt de gravure, par l'intermédiaire d'au moins un premier masque, de façon à ce que la couche d'arrêt de gravure structurée présente au moins un motif de ligne, ledit au moins un motif de ligne comprenant au moins une ouverture de via,
- une formation, sur la couche d'arrêt de gravure structurée comprenant l'au moins une ouverture de via, d'une deuxième couche métallique à base du deuxième matériau métallique,
- une formation, sur la deuxième couche métallique, d'un deuxième masque définissant au moins un motif de via à l'aplomb de l'au moins une ouverture de via,
- une gravure de la deuxième couche métallique, ladite gravure étant configurée pour former l'au moins un via sous le deuxième masque, puis
- une gravure de la première couche métallique, ladite gravure étant configurée pour former l'au moins une ligne sous l'au moins un motif de ligne de la couche d'arrêt de gravure structurée, ladite au moins une ligne étant connectée audit au moins un via au travers de l'au moins une ouverture de via.

Avantageusement, les premier et deuxième masques sont formés sur des couches planes, respectivement sur la couche d'arrêt de gravure et sur la deuxième couche métallique. Cela permet de limiter la variabilité dimensionnelle liée à la formation de ces masques, typiquement par lithographies.

Avantageusement, la couche d'arrêt de gravure est structurée de façon à exposer la première couche métallique en dehors de l'au moins un motif de ligne. Cela permet d'enchainer les gravures de la deuxième couche métallique et de la première couche métallique. La formation de l'au moins une ligne à partir de la première couche métallique est effectuée en fin de procédé. L'au moins une ligne est alignée à l'aplomb de l'au moins un motif de ligne. L'au moins un via est aligné à l'aplomb de l'au moins un motif de via. Cela évite de recourir à un alignement entre les deux gravures, contrairement à la solution divulguée dans le document EP3577700. Cela limite la variabilité dimensionnelle liée à un tel alignement.

L'invention prévoit également selon un deuxième aspect un dispositif comprenant en empilement suivant une direction z :
- un substrat,
- un niveau d'interconnexion comprenant
- au moins une ligne de connexion à base d'un premier matériau métallique A,
- une couche d'arrêt de gravure à base d'un matériau diélectrique C présentant une sélectivité à la gravure S_{A:C} vis-à-vis du premier matériau typiquement supérieure ou égale à 5:1,
- au moins un via de connexion à base d'un deuxième matériau métallique B.

La couche d'arrêt de gravure présente au moins un motif de ligne comprenant au moins une ouverture de via configurée pour connecter l'au moins un via de connexion et l'au moins une ligne de connexion.

Avantageusement, la couche d'arrêt de gravure couvre l'au moins une ligne de connexion selon la direction z, sans s'étendre en dehors de ladite au moins une ligne de connexion, en projection selon la direction z.

Les avantages décrits ci-dessus en regard du procédé s'appliquent *mutatis mutandis* au dispositif selon l'invention.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les figures 1 à 10 et 12 à 14 illustrent dans un plan xz, des coupes transversales représentant différentes étapes du procédé de fabrication d'un niveau d'interconnexion selon un mode de réalisation de la présente invention.
La figure 11 illustre schématiquement en vue de dessus une étape du procédé de fabrication correspondant à la figure 10, selon un mode de réalisation de la présente invention.
Les figures 15, 17, 19 illustrent schématiquement dans un plan xz, des coupes transversales représentant différentes étapes de structuration de la couche d'arrêt de gravure selon un autre mode de réalisation de la présente invention.
Les figures 16 et 18 illustrent schématiquement en vue de dessus les étapes du procédé de fabrication correspondant aux figures 15 et 17, respectivement.
Les figures 20 à 25 illustrent schématiquement dans un plan xz, des coupes transversales représentant différentes étapes de structuration de la couche d'arrêt de gravure selon un autre mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs et/ou les dimensions des différentes couches et motifs ne sont pas représentatives de la réalité. Pour des raisons de clarté, l'ensemble des références alphanumériques n'est pas systématiquement repris d'une figure à l'autre. Il est entendu que les éléments déjà décrits et référencés, lorsqu'ils sont reproduits sur une autre figure, portent typiquement les mêmes références alphanumériques, même si celles-ci ne sont pas explicitement mentionnées. L'homme du métier identifiera sans difficultés un même élément reproduit sur différentes figures.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement.

La structuration de la couche d'arrêt de gravure peut notamment se faire de différentes façons.

Selon un exemple, la structuration de la couche d'arrêt de gravure comprend les sous-étapes suivantes :
- une formation du premier masque sur la couche d'arrêt de gravure, ledit premier masque définissant de façon directe l'au moins un motif de ligne comprenant l'au moins une ouverture de via,
- un retrait partiel de la couche d'arrêt de gravure, uniquement au niveau de zones de la couche d'arrêt de gravure non couvertes par le premier masque, de façon à exposer la première couche métallique en dehors des zones couvertes par le premier masque,
- un retrait du premier masque.

La formation du premier masque se fait ici sur la couche d'arrêt de gravure, et couvre les parties de la couche d'arrêt de gravure qui seront conservées : le premier masque définit donc « directement » l'au moins un motif de ligne comprenant l'au moins une ouverture de via. L'au moins un motif de ligne se trouve sous le premier masque, à l'aplomb du premier masque.

Selon un exemple, la formation du premier masque se fait par double lithographie. Cela permet d'obtenir des motifs résolus au-delà des performances de l'équipement de lithographie.

Selon un exemple, la structuration de la couche d'arrêt de gravure comprend les sous-étapes suivantes :
- avant formation de la couche d'arrêt de gravure, une formation du premier masque sur la première couche métallique, ledit premier masque définissant de façon indirecte l'au moins un motif de ligne comprenant l'au moins une ouverture de via,
- la formation de la couche d'arrêt de gravure par dépôt sélectif du matériau diélectrique sur des zones de la première couche métallique non couvertes par le premier masque,
- un retrait du premier masque.

La formation du premier masque se fait ici avant la formation de la couche d'arrêt de gravure, et couvre les parties de la première couche métallique qui ne seront pas recouvertes par la couche d'arrêt de gravure : le premier masque définit donc « indirectement » l'au moins un motif de ligne comprenant l'au moins une ouverture de via. L'au moins un motif de ligne se trouve sur les parties de la première couche métallique non couvertes par le premier masque.

Selon un exemple, le dépôt sélectif du matériau diélectrique se fait par dépôt en couches atomiques (ALD, Atomic Layer Deposition). Selon un autre exemple, le dépôt sélectif du matériau diélectrique se fait par dépôt en phase vapeur (CVD, Chemical Vapor Deposition).

Selon un exemple, l'au moins un motif de via présente une dimension critique CD₂, prise selon un axe x, supérieure à une dimension CDₒₚₑₙ de l'au moins une ouverture de via prise selon l'axe x. Cela permet d'introduire une certaine tolérance dans l'alignement entre les premier et deuxième masques, notamment pour la définition des premier et deuxième masques par lithographie. Le deuxième masque peut ainsi recouvrir en partie les bords de l'ouverture de via du premier masque, en projection selon une direction d'empilement z. Selon un autre exemple, l'au moins un motif de via présente une dimension critique CD₂, prise selon un axe x, sensiblement égale à une dimension CDₒₚₑₙ de l'au moins une ouverture de via prise selon l'axe x.

Selon un exemple, l'au moins un motif de via présente une dimension critique CD₂, prise selon un axe x, inférieure à une dimension CD₁ de l'au moins un motif de ligne prise selon l'axe x.

Selon un exemple, la gravure de la deuxième couche métallique et la gravure de la première couche métallique sont enchainées selon une seule et même séquence de gravures. Cette séquence de gravures peut comporter plusieurs sous-étapes avec des conditions plasma différentes par exemple.

Selon un exemple, la gravure de la deuxième couche métallique et la gravure de la première couche métallique sont réalisées par une seule et même gravure, lors d'une seule et même étape. Les conditions de gravure restent sensiblement identiques lors de la gravure des deuxième et première couches métalliques. Cela permet de réduire la durée et/ou les coûts du procédé.

Selon un exemple, le premier matériau métallique A et/ou le deuxième matériau métallique B sont à base d'au moins l'un parmi : TiN, TaN, W, Ru, Ti, Ta, V3SI, CoSi2, Nb3Ge, AI, NbN, et leurs alliages.

Selon un exemple, le premier matériau métallique A et le deuxième matériau métallique B sont à base du même matériau.

Selon un exemple, le premier matériau métallique A et/ou le deuxième matériau métallique B sont différents du cuivre.

Selon un exemple, la couche d'arrêt de gravure à base d'un matériau diélectrique C présente une sélectivité S_{A:C} à la gravure vis-à-vis du premier matériau A supérieure ou égale à 5:1.

Selon un exemple, la couche d'arrêt de gravure est à base d'un matériau diélectrique C pris parmi : SiO2, TiO2, HfO2, HfN, ZrN, SiN, SiCN. Cela permet d'obtenir une sélectivité S_{A:C} à la gravure entre le premier matériau métallique A et le matériau diélectrique C supérieure ou égale à 5:1. La vitesse de gravure de la couche d'arrêt de gravure est au moins cinq fois inférieure à la vitesse de gravure des première et deuxième couches métalliques. Selon un exemple, la sélectivité S_{A:B} à la gravure entre le premier matériau métallique A et le matériau diélectrique C est supérieure à 10:1.

Selon un exemple, l'au moins un via de connexion présente une dimension critique CDᵥᵢₐ, prise selon un axe x, supérieure à une dimension CDₒₚₑₙ de l'au moins une ouverture de via prise selon l'axe x, et inférieure à une dimension CD_{ligne} de l'au moins une ligne de connexion prise selon l'axe x, de sorte que la couche d'arrêt de gravure est partiellement intercalée entre l'au moins un via de connexion et l'au moins une ligne de connexion.

Selon un autre exemple, l'au moins un via de connexion présente une dimension critique CDᵥᵢₐ, prise selon un axe x, sensiblement égale à une dimension CD_{ligne} de l'au moins une ligne de connexion prise selon l'axe x, de sorte que la couche d'arrêt de gravure est prise en sandwich entre l'au moins un via de connexion et l'au moins une ligne de connexion.

Selon un exemple, l'au moins une ligne de connexion présente une dimension critique CD_{ligne}, prise selon un axe x, sensiblement égale à une dimension CD₁, prise selon l'axe x, de l'au moins un motif de ligne de la couche d'arrêt de gravure.

Selon un exemple, l'au moins une ligne de connexion présente une dimension critique CD_{ligne}, prise selon un axe x, sensiblement égale à une dimension critique CDᵥᵢₐ, prise selon l'axe x, de l'au moins un via de connexion.

Sauf incompatibilité, il est entendu que l'ensemble des caractéristiques optionnelles ci-dessus et/ou les variantes indiquées peuvent être combinées de façon à former un mode de réalisation qui n'est pas nécessairement illustré ou décrit. Un tel mode de réalisation n'est évidemment pas exclu de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage. Ainsi, un espaceur à base de nitrure de silicium SiN peut par exemple comprendre du nitrure de silicium non stœchiométrique (SiN), ou du nitrure de silicium stœchiométrique (Si₃N₄), ou encore un oxy-nitrure de silicium (SiON).

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 20, et de préférence inférieure à 10.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé. Les gravures des première et deuxième couches métalliques peuvent notamment être enchaînées ou être considérées comme faisant partie d'une seule et même étape de gravure.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. Elle est notée S_{A:B}. Une sélectivité S_{A:B} de 10:1 signifie que la vitesse de gravure du matériau A est 10 fois supérieure à la vitesse de gravure du matériau B.

Un repère de préférence orthonormé, comprenant les axes x, y, z est représenté sur les figures annexées.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche métallique présente typiquement une épaisseur selon z. Un via formé à partir d'une telle couche métallique présente une hauteur selon z. Les termes relatifs « sur », « surmonte », « supérieur », « sous », « sous-jacent » « inférieur » se réfèrent à des positions prises selon la direction z. Une dimension « latérale » correspond à une dimension selon une direction du plan xy. On entend par une extension « latérale » ou « latéralement », une extension selon une ou des directions du plan xy.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

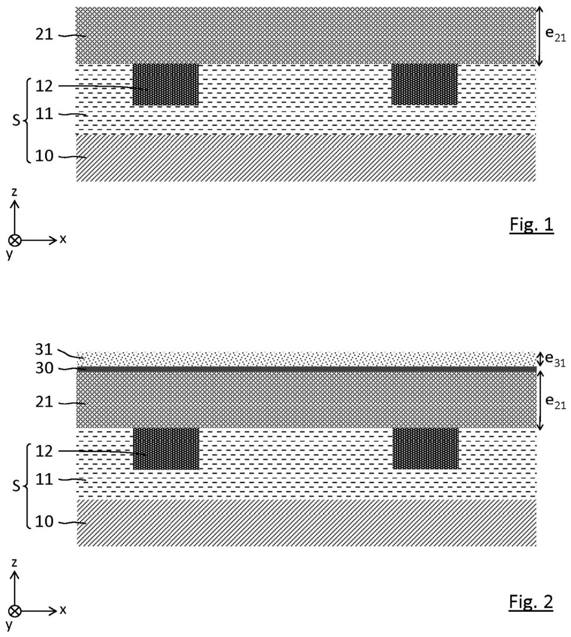

Les étapes de fabrication d'un niveau d'interconnexion selon un premier mode de réalisation de l'invention sont illustrées aux figures 1 à 14.

Comme illustré à la figure 1, le procédé comprend une fourniture d'un substrat S comprenant typiquement une couche de support 10 à base de silicium portant des composants, par exemple des transistors à qubits de spin ou à qubits supraconducteur. Le substrat S peut également comprendre des plots de connexion 12 intégrés dans une première couche 11 à base d'oxyde de silicium, surmontant la couche de support 10. Un objectif du procédé selon l'invention est de former des lignes connectant les plots 12, et des vias surmontant et connectant ces lignes.

Une première couche métallique 21 est d'abord formée sur le substrat S. La première couche métallique 21 peut être formée à partir d'un ou plusieurs matériaux parmi Ti, TiN, Ta, TaN, W, Ru, V3Si, CoSi2, Nb3Ge, Al, NbN. La première couche métallique 21 peut notamment être formée par dépôt physique en phase vapeur (PVD, acronyme de « Physical Vapor Deposition »). Cette couche métallique 21 présente typiquement une épaisseur e₂₁ de l'ordre de quelques dizaines de nanomètres, par exemple de l'ordre de 40 nm. Après dépôt, la première couche métallique 21 est typiquement planarisée, par exemple de façon classique par polissage mécano-chimique (CMP).

Comme illustré à la figure 2, une couche d'arrêt de gravure 30 est ensuite directement formée sur la première couche métallique 21. Cette couche d'arrêt de gravure 30 présente typiquement une épaisseur de l'ordre de quelques nanomètres, par exemple inférieure à 5 nm. Elle est de préférence à base d'un diélectrique pris parmi SiO2, TiO2, HfO2, HfN, ZrN, SiN, SiCN. La formation de la couche d'arrêt de gravure 30 peut notamment être effectuée par l'une des techniques suivantes: dépôt physique en phase vapeur (PVD, acronyme de « physical vapor deposition »), dépôt chimique en phase vapeur (CVD, acronyme de « chemical vapor deposition »), dépôt chimique en phase vapeur assisté par plasma (PECVD, acronyme de « plasma enhanced chemical vapor deposition »), dépôt par couche atomique (ALD, acronyme de « atomic layer deposition »), dépôt par couche atomique assisté par plasma (PEALD, acronyme de « plasma enhanced atomic layer deposition »).

Une couche 31 dite de colorisation, destinée à former un premier masque de gravure, est déposée sur la couche d'arrêt de gravure 30. Cette couche de colorisation 31 est par exemple à base de SiON. Elle présente typiquement une épaisseur e₃₁ de l'ordre de quelques nanomètres à quelques dizaines de nanomètres, par exemple de l'ordre de 5 nm à 10 nm. La couche de colorisation 31 est ensuite structurée par lithographie/gravure de façon à former le premier masque de gravure. Cette structuration peut se faire par lithographie simple, par exemple en insolation extrême UV, ou par double lithographie connue sous l'appellation « double patterning ».

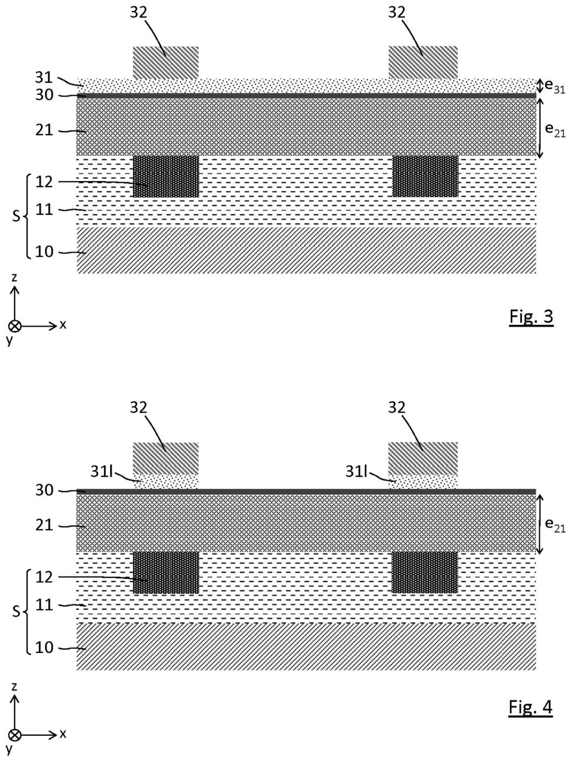

Les figures 3 à 8 illustrent une structuration de la couche de colorisation 31 par « double patterning ».

Comme illustré à la figure 3, une première lithographie peut être effectuée de façon à définir des motifs de ligne 32 dans une première couche de résine photosensible, de préférence à l'aplomb des plots 12.

Comme illustré à la figure 4, une première gravure peut ensuite être effectuée de façon à transférer les motifs de ligne 32 dans la couche de colorisation 31. La couche de colorisation est ainsi partiellement structurée. Cette première structuration partielle permet d'obtenir des motifs de ligne 31l dans la couche de colorisation.

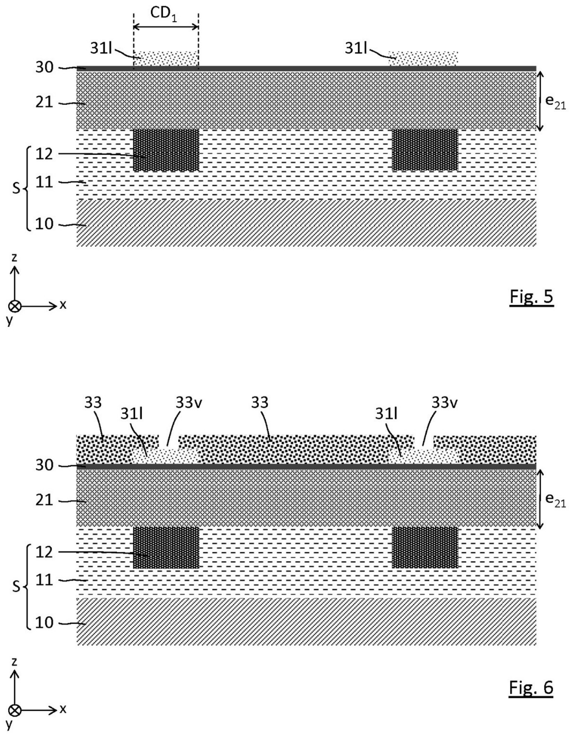

Comme illustré à la figure 5, les motifs de ligne 32 de la première couche de résine sont ensuite retirés, par exemple par plasma à base d'oxygène, de façon à réexposer les motifs de ligne 31l de la couche de colorisation partiellement structurée. Dans le cas de la structuration par « double patterning », les motifs de ligne 31l présentent typiquement une dimension CD₁, selon x, comprise entre 70 nm et 100 nm, par exemple de l'ordre de 80 nm.

Comme illustré à la figure 6, une deuxième lithographie peut être effectuée de façon à définir des motifs d'ouverture de via 33v dans une deuxième couche 33 de résine photosensible, sur les motifs de ligne 31l de la couche de colorisation partiellement structurée.

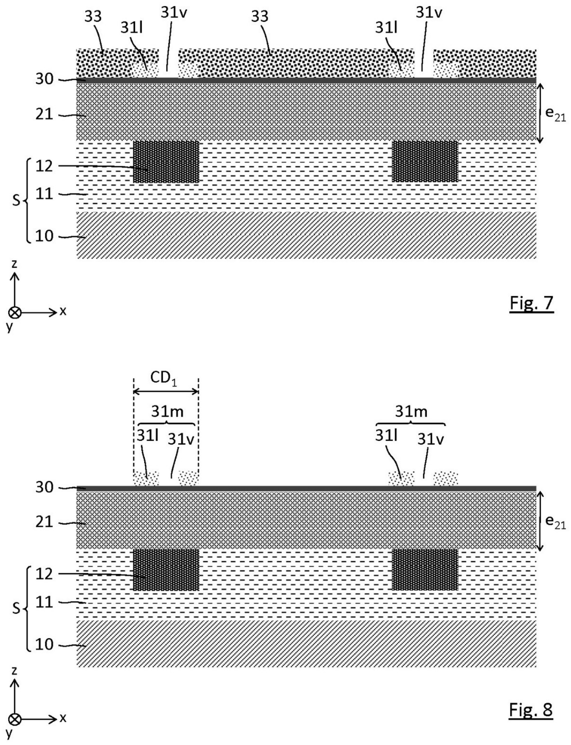

Comme illustré à la figure 7, une deuxième gravure peut être effectuée de façon à compléter la structuration de la couche de colorisation. Les motifs d'ouverture de via 33v sont transférés dans la couche de colorisation. Cette deuxième structuration permet d'obtenir des motifs d'ouverture de via 31v au sein des motifs de ligne 31l de la couche de colorisation.

Comme illustré à la figure 8, après retrait de la deuxième couche 33 de résine, un premier masque de gravure 31m comprenant des motifs de ligne 31l et des motifs d'ouverture de via 31v est formé sur la couche d'arrêt de gravure 30.

Le premier masque de gravure n'est pas nécessairement à base d'une couche de coloration, ni nécessairement réalisé par « double patterning ». Lorsque le premier masque de gravure est réalisé par lithographie simple, la dimension CD₁ des motifs de ligne 31l est typiquement comprise entre 100 nm et 200 nm, par exemple de l'ordre de 130 nm. Lorsque le premier masque de gravure est réalisé par lithographie extrême UV, la dimension CD₁ des motifs de ligne 31l est typiquement comprise entre 20 nm et 50 nm, par exemple de l'ordre de 26 nm. Ce premier masque de gravure 31m est ici utilisé pour transférer directement les motifs de ligne 31l et les motifs d'ouverture de via 31v dans la couche d'arrêt de gravure 30.

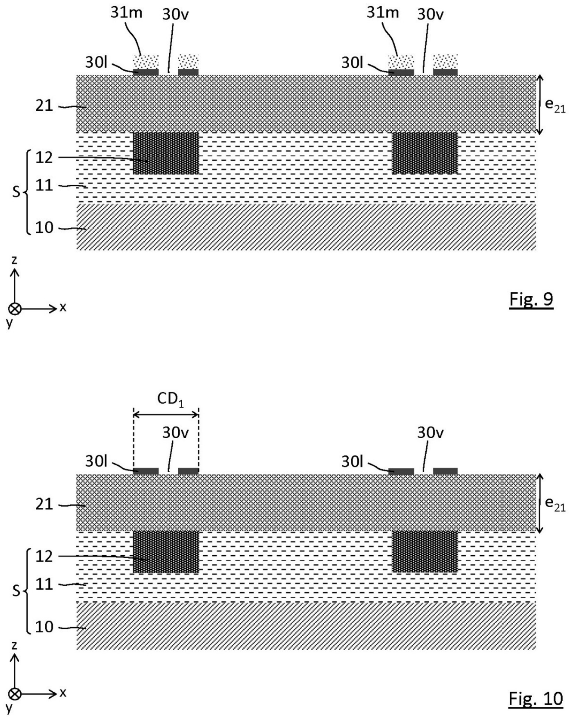

Comme illustré à la figure 9, une gravure anisotrope de la couche d'arrêt de gravure 30, selon z, est effectuée de façon à former les motifs de ligne 30l sous les motifs de ligne 31l, et les motifs d'ouverture de via 30v sous les motifs d'ouverture de via 31v. Cette gravure peut présenter une chimie de gravure halogénée à base de chlore ou de fluor, selon le type de masque 31m et la nature de la couche d'arrêt de gravure 30. Pour une couche d'arrêt de gravure 30 à base d'hafnium, la gravure peut se faire à partir d'une chimie de gravure BCl₃. Pour une couche d'arrêt de gravure 30 à base de silicium, la gravure peut se faire à partir d'une chimie de gravure fluorocarbonnée, par exemple CF₄.

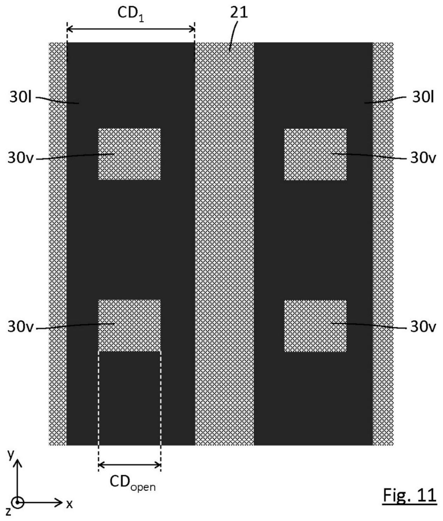

Comme illustré aux figures 10 et 11, en vue transverse et en vue de dessus respectivement, après retrait du premier masque de gravure 31m, une couche d'arrêt de gravure structurée, comprenant des motifs de ligne 30l et des motifs d'ouverture de via 30v, est obtenue sur la première couche métallique 21. Les motifs de ligne 30l présentent typiquement la dimension CD₁ selon x, et les motifs d'ouverture de via 30v présentent typiquement la dimension CDₒₚₑₙ selon x. Lorsque le premier masque de gravure est réalisé par lithographie simple ou par « double patterning », la dimension CDₒₚₑₙ des motifs d'ouverture de via 30v est typiquement comprise entre 30 nm et 70 nm, par exemple de l'ordre de 50 nm. Lorsque le premier masque de gravure est réalisé par lithographie extrême UV, la dimension CDₒₚₑₙ des motifs d'ouverture de via 30v peut être comprise entre 8 nm et 20 nm, par exemple de l'ordre de 10 nm.

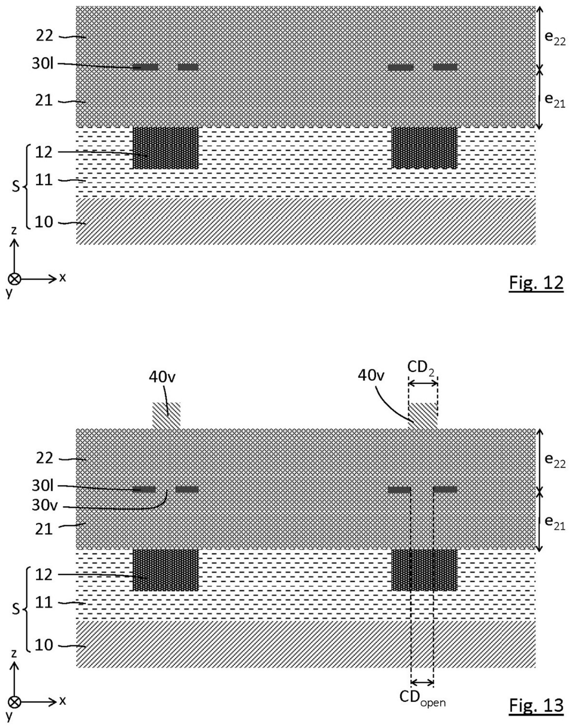

Comme illustré à la figure 12, après structuration de la couche d'arrêt de gravure, une deuxième couche métallique 22, typiquement à base du ou des mêmes métaux que la première couche métallique 21, est ensuite formée sur la première couche métallique 21 et sur la couche d'arrêt de gravure structurée 30l. Cette couche métallique 22 présente typiquement une épaisseur e₂₂ de l'ordre de quelques dizaines de nanomètres, par exemple de l'ordre de 40 nm. Les épaisseurs e₂₁ et e₂₂ sont de préférence choisies de façon à ce que l'épaisseur totale e₂₁ + e₂₂ des couches métalliques 21, 22 soit comprise entre 90 nm et 110 nm. Après dépôt, la deuxième couche métallique 22 est typiquement planarisée, par exemple de façon classique par polissage mécano-chimique (CMP).

Comme illustré à la figure 13, un deuxième masque de gravure 40 comprenant des motifs de via 40v est formé sur la deuxième couche métallique 22. Ce deuxième masque de gravure 40 est de préférence à base de couches organiques, par exemple sous forme d'un empilement connu sous la dénomination « trilayer », comprenant typiquement une couche de planarisation organique, une couche antireflets et une couche de résine photosensible.

Les motifs de via 40v de ce deuxième masque de gravure 40 sont alignés avec les motifs d'ouverture de via 30v de la couche d'arrêt de gravure, de façon à ce que les motifs de via 40v soient à l'aplomb des motifs d'ouverture de via 30v. Les motifs de via 40v présentent typiquement une dimension CD₂ selon x légèrement supérieure, par exemple 10% supérieure, à la dimension CDₒₚₑₙ selon x des motifs de via 30v. Cela facilite l'alignement des motifs 40v, 30v entre eux. Une certaine tolérance sur la précision d'alignement est ainsi obtenue.

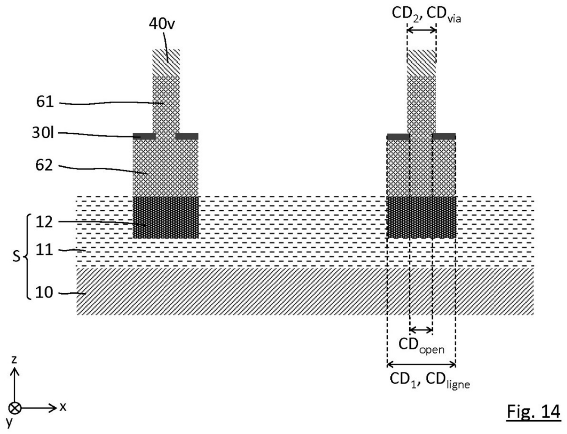

Comme illustré à la figure 14, les première et deuxième couches métalliques 21, 22 sont ensuite gravées sur toute leur épaisseur, selon z, en dehors des motifs de via 40v. La deuxième couche métallique 22 est d'abord gravée pour former les vias de connexion 61, puis la première couche métallique 21 est gravée pour former les lignes de connexion 62. Les gravures des première et deuxième couches métalliques 21, 22 sont de préférence enchaînées. Selon une possibilité, notamment lorsque les première et deuxième couches métalliques 21, 22 sont de nature identique, les gravures de ces couches métalliques 21, 22 sont effectuées en une seule et même étape, avec la même chimie de gravure.

Les gravures sont ici choisies de façon à graver sélectivement les premier et deuxième métaux des première et deuxième couches métalliques 21, 22 vis-à-vis du matériau de la couche d'arrêt de gravure. En particulier, la sélectivité de gravure S_{A:C}, c'est-à-dire le rapport entre la vitesse de gravure du ou des matériaux métalliques sur la vitesse de gravure du matériau de la couche d'arrêt de gravure, est supérieure ou égale à 5:1, de préférence supérieure ou égale à 10:1.

La ou les gravures du ou des matériaux métalliques peuvent être effectuées en chimie chlorée. Dans ce cas, une bonne sélectivité est obtenue vis-à-vis de la couche d'arrêt de gravure. En particulier, lorsque celle-ci est à base de HfO2 ou de SiO2, la vitesse de gravure de la couche d'arrêt de gravure est inférieure à 20 nm/min. Alternativement, la ou les gravures du ou des matériaux métalliques peuvent être effectuées en chimie fluorée ou fluoro-carbonée. Dans ce cas, il est préférable d'éviter SiN et SiO2 comme matériau diélectrique de la couche d'arrêt de gravure.

Après gravure, des vias métalliques 61 présentant une dimension critique CDᵥᵢₐ selon x sont obtenus. La dimension critique CDᵥᵢₐ selon x est sensiblement égale à la dimension CD₂ des motifs de via 40v. Des lignes métalliques 62 présentant une dimension critique CD_{ligne} selon x sont obtenues. La dimension critique CD_{ligne} selon x est sensiblement égale à la dimension CD₁ des motifs de ligne 30l. Les vias métalliques 61 sont connectés aux lignes métalliques 62 par continuité de matière du matériau métallique au travers des ouvertures de via 30v.

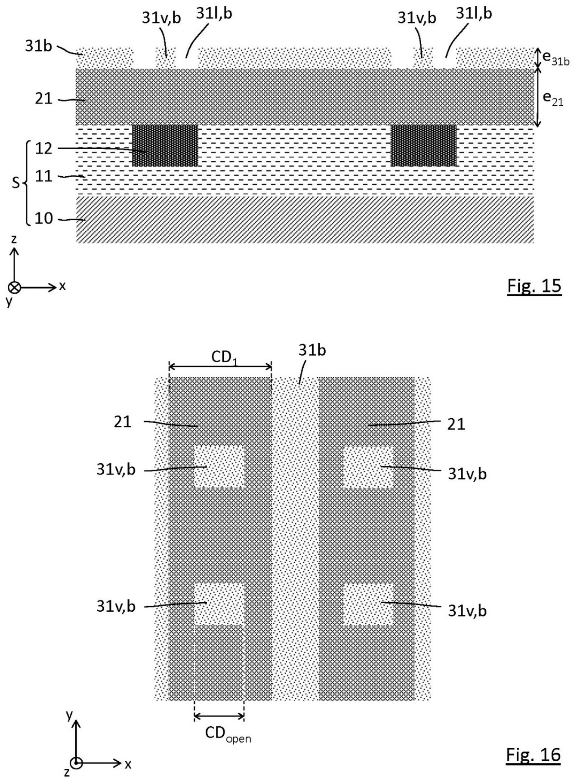

Les figures 15 à 19 illustrent une structuration de la couche d'arrêt de gravure selon un autre mode de réalisation de l'invention.

Comme illustré aux figures 15, 16, un premier masque 31b à base de résine de polarité inversée est d'abord formé directement sur la première couche métallique 21. Il comprend des plots 31v,b de dimension CDₒₚₑₙ selon x, définissant les ouvertures de via, et des ouvertures 31l,b de dimension CD₁ selon x, définissant les motifs de lignes.

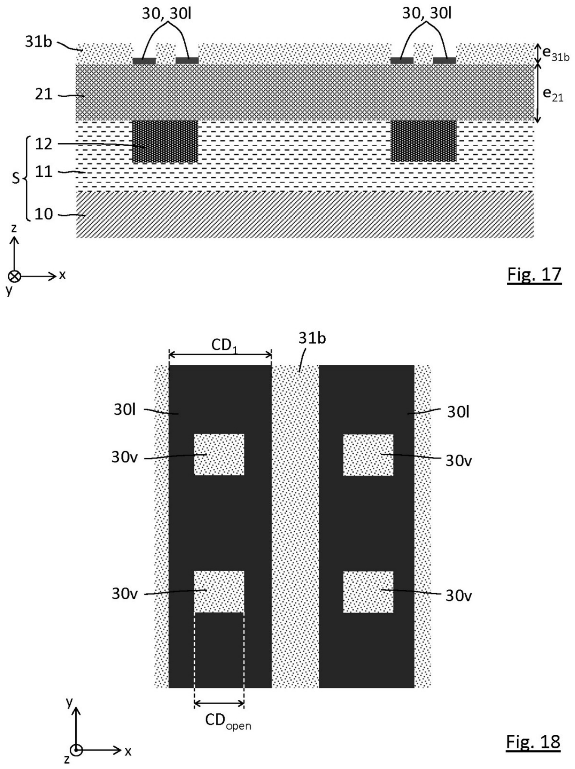

Comme illustré aux figures 17, 18, un dépôt sélectif du matériau diélectrique B est effectué dans les ouvertures 31l,b, sur la première couche métallique 21. Ce dépôt peut typiquement se faire par dépôt en couche atomique (ALD). Cela permet de former une couche d'arrêt de gravure 30l directement structurée. La structuration de la couche d'arrêt de gravure par lithographie/gravure est ainsi évitée. Cela permet de préserver la surface de la première couche métallique 21, en particulier sous les plots 31v,b. La qualité de l'interface obtenue ultérieurement entre le via et la ligne sous-jacente est ainsi préservée.

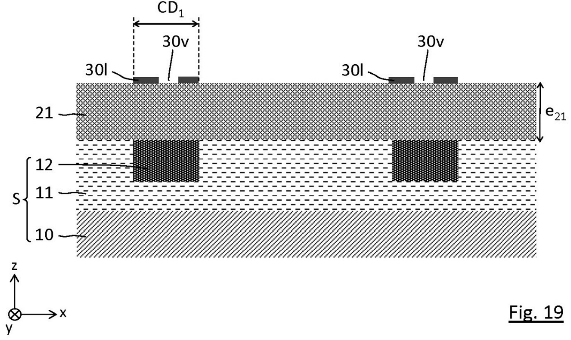

Comme illustré à la figure 19, le premier masque 31b à base de résine est ensuite retiré, typiquement par plasma O2/N2. Une couche d'arrêt de gravure 30 directement structurée est ainsi obtenue. Les étapes ultérieures de formation des vias et des lignes sont identiques à celles décrites précédemment.

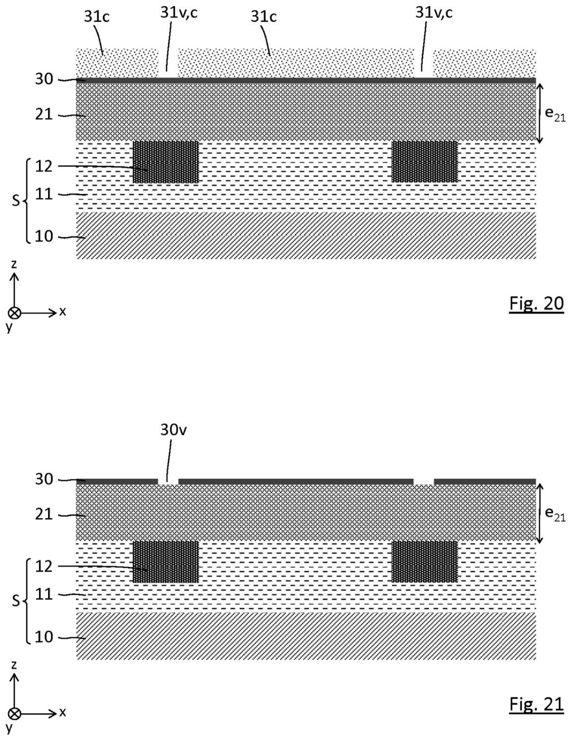

Les figures 20 à 25 illustrent une structuration de la couche d'arrêt de gravure selon un autre mode de réalisation de l'invention.

Comme illustré à la figure 20, un masque 31c à base de résine est formé sur la couche d'arrêt de gravure 30. Il comprend uniquement des ouvertures 31v,b de dimension CDₒₚₑₙ selon x, définissant les ouvertures de via.

Comme illustré à la figure 21, une gravure au travers des ouvertures 31v,b permet de former les ouvertures de via 30v dans la couche d'arrêt de gravure 30. La couche d'arrêt de gravure 30 est ici partiellement structurée et ne comprend à ce stade que les ouvertures de via 30v.

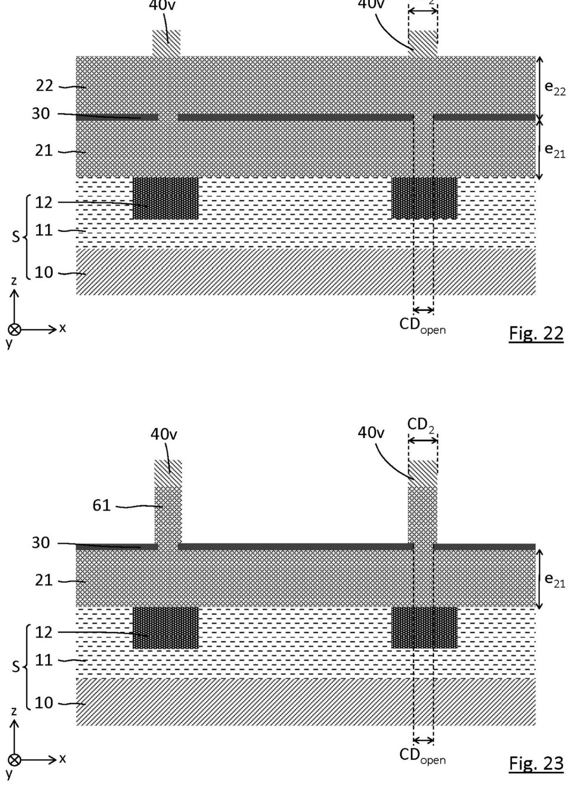

Comme illustré à la figure 22, la deuxième couche métallique 22 est ensuite formée sur la couche d'arrêt de gravure partiellement structurée et dans les ouvertures de via 30v. Un masque de gravure comprenant des motifs de via 40v est formé sur la deuxième couche métallique 22, comme précédemment. Les motifs de vias 40v présentent une dimension CD₂.

Comme illustré à la figure 23, la deuxième couche métallique 22 est ensuite gravée avec arrêt sur la couche d'arrêt de gravure, afin de former les vias de connexion 61.

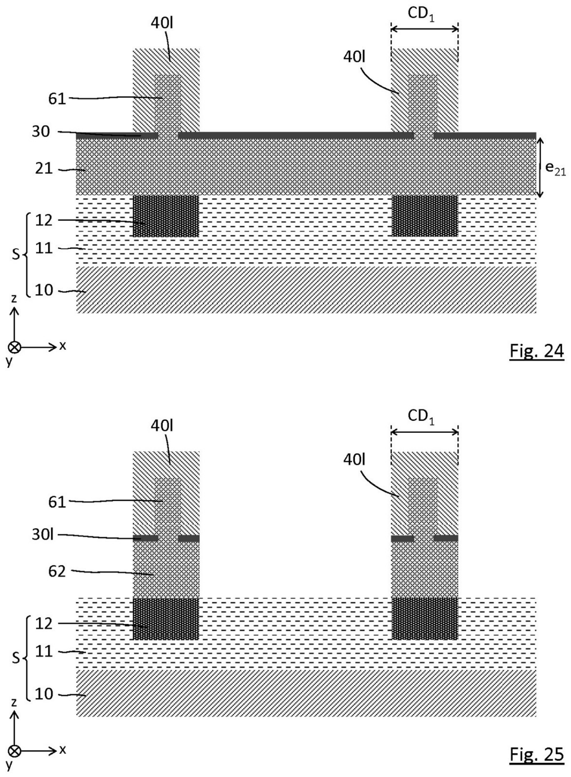

Comme illustré à la figure 24, un masque de gravure comprenant des motifs de lignes 40l est formé sur et autour des vias de connexion 61, de préférence à l'aplomb des plots de connexion 12. Les motifs de lignes 40l présentent une dimension CD₁.

Comme illustré à la figure 25, une ou plusieurs gravures sont ensuite effectuées pour retirer la couche d'arrêt de gravure 30 puis la première couche métallique 21 en dehors des zones couvertes par les motifs de lignes 40l. Des lignes de connexion 62 sont ainsi formées. Cette variante permet d'envisager des couples de matériaux A, C présentant une sélectivité à la gravure S_{A:C} plus faible.

Au vu de la description qui précède, il apparaît clairement que le procédé et le dispositif proposés offrent une solution particulièrement efficace et versatile pour former des niveaux d'interconnexions à base de vias et de lignes métalliques adaptés à la fabrication de circuits radiofréquence et/ou supraconducteurs.

L'invention n'est pas limitée aux modes de réalisations précédemment décrits.

## Revendications

1. Procédé de fabrication d'un niveau d'interconnexion comprenant au moins une ligne (62) à base d'un premier matériau métallique (A) et au moins un via (61) à base d'un deuxième matériau métallique (B), ledit procédé comprenant :
• une fourniture d'un substrat (S),
• une formation, sur le substrat (S), d'une première couche métallique (21) à base du premier matériau métallique (A),
• une formation, sur la première couche métallique (21), d'une couche d'arrêt de gravure (30) à base d'un matériau diélectrique (C) présentant une sélectivité S_{A:C} à la gravure vis-à-vis du premier matériau (A),
• une structuration de la couche d'arrêt de gravure (30), par l'intermédiaire d'au moins un premier masque (31m, 31b, 31c), de façon à ce que la couche d'arrêt de gravure structurée présente au moins un motif de ligne (30l), ledit motif de ligne (30l) comprenant au moins une ouverture de via (30v),
• une formation, sur la couche d'arrêt de gravure structurée comprenant l'au moins une ouverture de via (30v), d'une deuxième couche métallique (22) à base du deuxième matériau (B) métallique,
• une formation, sur la deuxième couche métallique (22), d'un deuxième masque définissant au moins un motif de via (40v) à l'aplomb de l'au moins une ouverture de via (30v),
• une gravure de la deuxième couche métallique (22), ladite gravure étant configurée pour former l'au moins un via (61) sous le deuxième masque, puis
• une gravure de la première couche métallique (21), ladite gravure étant configurée pour former l'au moins une ligne (62) sous l'au moins un motif de ligne (30l) de la couche d'arrêt de gravure structurée, ladite au moins une ligne (62) étant connectée audit au moins un via (61) au travers de l'au moins une ouverture de via (30v).

2. Procédé selon la revendication précédente, dans lequel la structuration de la couche d'arrêt de gravure (30) comprend les sous-étapes suivantes :
• une formation du premier masque (31m) sur la couche d'arrêt de gravure, ledit premier masque (31m) définissant de façon directe l'au moins un motif de ligne (31l, 30l) comprenant l'au moins une ouverture de via (31v, 30v),
• un retrait partiel de la couche d'arrêt de gravure (30), uniquement au niveau de zones de la couche d'arrêt de gravure (30) non couvertes par le premier masque (31m), de façon à exposer la première couche métallique (21) en dehors des zones couvertes par le premier masque (31m),
• un retrait du premier masque (31m).

3. Procédé selon la revendication précédente, dans lequel la formation du premier masque (31m) se fait par double lithographie.

4. Procédé selon la revendication 1, dans lequel la structuration de la couche d'arrêt de gravure (30) comprend les sous-étapes suivantes :
• avant formation de la couche d'arrêt de gravure (30), une formation du premier masque (31b) sur la première couche métallique (21), ledit premier masque (31b) définissant de façon indirecte l'au moins un motif de ligne (31l,b, 30l) comprenant l'au moins une ouverture de via (31v,b, 30v),
• la formation de la couche d'arrêt de gravure (30, 30l) par dépôt sélectif du matériau diélectrique (C) sur des zones de la première couche métallique (21) non couvertes par le premier masque (31b),
• un retrait du premier masque (31b).

5. Procédé selon la revendication précédente, dans lequel le dépôt sélectif du matériau diélectrique (C) se fait par dépôt en couches atomiques (ALD) ou par dépôt en phase vapeur (CVD).

6. Procédé selon l'une quelconque des revendications précédentes, dans lequel l'au moins un motif de via (40v) présente une dimension critique CD₂, prise selon un axe x, supérieure à une dimension CDₒₚₑₙ de l'au moins une ouverture de via (30v) prise selon l'axe x, et inférieure à une dimension CD₁ de l'au moins un motif de ligne (30l) prise selon l'axe x.

7. Procédé selon l'une quelconque des revendications précédentes, dans lequel la gravure de la deuxième couche métallique (22) et la gravure de la première couche métallique (21) sont enchainées selon une seule et même séquence de gravures.

8. Procédé selon l'une quelconque des revendications précédentes, dans lequel le premier matériau métallique (A) et/ou le deuxième matériau métallique (B) sont à base d'au moins l'un parmi : TiN, TaN, W, Ru, Ti, Ta, V3SI, CoSi2, Nb3Ge, Al, NbN.

9. Procédé selon l'une quelconque des revendications précédentes, dans lequel le premier matériau métallique (A) et le deuxième matériau métallique (B) sont à base du même matériau.

10. Procédé selon l'une quelconque des revendications précédentes, dans lequel la couche d'arrêt de gravure (30) est à base d'un matériau diélectrique (C) pris parmi : SiO2, TiO2, HfO2, HfN, ZrN, SiN, SiCN.

11. Dispositif comprenant en empilement suivant une direction z :
• un substrat (S),
• un niveau d'interconnexion comprenant
∘ au moins une ligne de connexion (62) à base d'un premier matériau métallique (A),
∘ une couche d'arrêt de gravure (30) à base d'un deuxième matériau diélectrique (C) présentant une sélectivité à la gravure S_{A:C} vis-à-vis du premier matériau (A),
o au moins un via de connexion (61) à base d'un deuxième matériau métallique (B),
ladite couche d'arrêt de gravure (30) présentant au moins un motif de ligne (30l) comprenant au moins une ouverture de via (30v) configurée pour connecter l'au moins un via de connexion (61) et l'au moins une ligne de connexion (62),
ledit dispositif étant **caractérisé en ce que** la couche d'arrêt de gravure (30, 30l) couvre l'au moins une ligne de connexion (62) selon la direction z, sans s'étendre en dehors de ladite au moins une ligne de connexion (62), en projection selon la direction z.

12. Dispositif selon la revendication précédente, dans lequel l'au moins un via de connexion (61) présente une dimension critique CDᵥᵢₐ, prise selon un axe x, supérieure à une dimension CDₒₚₑₙ de l'au moins une ouverture de via (30v) prise selon l'axe x, et inférieure à une dimension CD_{ligne} de l'au moins une ligne de connexion (62) prise selon l'axe x, de sorte que la couche d'arrêt de gravure (30, 30l) est partiellement intercalée entre l'au moins un via de connexion (61) et l'au moins une ligne de connexion (62).

13. Dispositif selon l'une quelconque des revendications 11 à 12, dans lequel l'au moins une ligne de connexion (62) présente une dimension critique CD_{ligne}, prise selon un axe x, sensiblement égale à une dimension critique CDᵥᵢₐ, prise selon l'axe x, de l'au moins un via de connexion (61).

14. Dispositif selon l'une quelconque des revendications 11 à 13, dans lequel le premier matériau métallique (A) est à base d'au moins l'un parmi : TiN, TaN, W, Ru, Ti, Ta, V3SI, CoSi2, Nb3Ge, AI, NbN, et leurs alliages.
